# EUROPÄISCHE PATENTSCHRIFT

(11) **EP 0 858 248 B1**
(45) Veröffentlichungstag und Bekanntmachung des Hinweises auf die Patenterteilung: **14.05.2003**
(21) Anmeldenummer: 98200135.6
(22) Anmeldetag: 20.01.1998
(51) Int. Cl.: H05G 1/08, H01L 41/107

(54) **Röntgeneinrichtung mit einem piezoelektrischen Transformator**
X-ray arrangement with a piezoelectric transformer
Dispositif à rayons X comportant un transformateur piézoélectrique

(30) Priorität: 29.01.1997 DE 19703136
(43) Veröffentlichungstag der Anmeldung: 12.08.1998
(73) Patentinhaber: Philips Intellectual Property & Standards GmbH, 20099 Hamburg (DE); Koninklijke Philips Electronics N.V., 5621 BA Eindhoven (NL)
(72) Erfinder: v. Hacht, Reinhard, Röntgenstrasse 24, 22335 Hamburg (DE); Peter, Diethard, Röntgenstrasse 24, 22335 Hamburg (DE); Schaaf, Uwe, Dr., Röntgenstrasse 24, 22335 Hamburg (DE); van der Broeck, Heinz, Dr., Röntgenstrasse 24, 22335 Hamburg (DE); Wimmer, Martin, Röntgenstrasse 24, 22335 Hamburg (DE); Lunding, Arne, Röntgenstrasse 24, 22335 Hamburg (DE)
(74) Vertreter: Volmer, Georg, Dipl.-Ing.

(56) Entgegenhaltungen:
- EP-A- 0 693 789
- EP-A- 0 727 831
- US-A- 3 217 164
- US-A- 3 567 940
- US-A- 5 118 982
- US-A- 5 329 200
- O. OHNISHI ET AL.: "PIEZOELECTRIC CERAMIC TRANSFORMER FOR POWER SUPPLY OPERATING IN THICKNESS EXTENSIONAL VIBRATION MODE" IEICE TRANSACTIONS ON FUNDAMENTALS OF ELECTRONICS, COMMUNICATIONS AND COMPUTER SCIENCES., Bd. E77-A, Nr. 12, Dezember 1994, TOKYO JP, Seiten 2098-2105, XP000497870
- LEE DE FOREST: "The Audion-Detector and Amplifier", PROCEEDINGS OF THE IEEE, , September 1998, Band 86, Nr. 9, Seiten 1881 - 1888

## Beschreibung

Die Erfindung betrifft eine Röntgeneinrichtung mit einer Röntgenröhre mit Mitteln zur Beeinflussung des durch die Röntgenröhre fließenden Elektronenstroms. Die Erfindung betrifft ferner einen piezoelektrischen Transformator mit mindestens zwei Piezoelementen.

Bei Röntgenröhren ist mittels eines Gitters, an das eine gegenüber dem Kathodenpotential negative Gitterspannung angelegt werden kann, eine direkte Abschaltung des Röhrenstroms und damit der Röntgenstrahlung möglich. Die Röntgenröhre kann dadurch mit konstanter Hochspannung betrieben werden und es entsteht keine unerwünschte, den Patienten und das Personal belastende weiche Röntgenstrahlung. Die Ansteuerung des Gitters erfolgt auf dem Hochspannungspotential der Kathode, welches gegen Erde beispielsweise -75 kV betragen kann. Mittels einer komplexen Gittersteuerungselektronik werden die erforderlichen Spannungen für den Sperr- bzw. Durchlaßbetrieb der Röntgenröhre erzeugt. Eine derartige Röntgenröhre ist aus der DE-OS 20 07 246 bekannt.

Mittels einer elektrostatischen Ablenkvorrichtung können bei einer Röntgenröhre auch die von der Kathode emittierten Elektronen abgelenkt werden, um den Auftreffpunkt (Fokus) der Elektronen auf der Anode variieren zu können. Eine derartige Röntgenröhre, bei der die Steuerspannungen für die elektrostatische Ablenkvorrichtung mittels einer komplexen Elektronik erzeugt werden, ist aus der EP-B1-480 796 bekannt.

Piezoelektrische Transformatoren sind bekannte elektrische Bauelemente, die den direkten piezoelektrischen Effekt und gleichzeitig dessen Umkehrung in einem Bauelement ausnutzen. Elektrische Energie wird zunächst in einem ersten Piezoelement in mechanische Energie umgewandelt, und diese wird nach interner Übertragung mechanischer Energie vom ersten zu einem zweiten Piezoelement im zweiten Piezoelement wieder in elektrische Energie gewandelt. Ein piezoelektrischer Transformator wird als Spannungswandler benutzt, der beispielsweise eine eingangsseitig angelegte Niederspannung in eine Hochspannung am Ausgang transformiert. Ein piezoelektrischer Transformator kann dabei eine sehr hohe Spannungsübertragung aufweisen.

Häufig besteht das Problem, daß ein Signal transformiert werden soll, wobei gleichzeitig das (zu transformierende) Signal auf einem anderen Potential liegt als das (transformierte) Ausgangssignal. Deshalb müssen häufig Maßnahmen zur Potentialtrennung zwischen Eingangs- und Ausgangssignal vorgesehen werden.

Solche piezoelektrischen Transformatoren mit integrierter Potentialtrennung sind in verschiedenen Ausführungsformen zum Beispiel aus US-A-5 118 982 bekannt. Nachteile der bekannten piezoelektrischen Transformatoren sind aber beispielsweise, daß sie nur resonant, das heißt mit bestimmten, durch physikalische Eigenschaften vorgegeben Wechselspannungen betrieben werden können. Weiterhin wird als Mittel zur Potentialtrennung ein Isolatorelement zwischen den Piezoelementen eingesetzt, dessen Spannungsfestigkeit eingeschränkt ist. Aufgrund der resonanten Betriebsweise beispielsweise darf die Dicke des Isolatorelements einen bestimmten Wert nicht überschreiten.

Der generelle Einsatz von piezoelektrischen Elementen in einem Röntgensystem ist beispielsweise aus US-A-3217164 bekannt, wo ein piezoelektrischer Generator die Betriebs-Hochspannung der Röntgenröhre erzeugt.

Der Erfindung liegt die Aufgabe zugrunde, eine Röntgenröhre mit einfacher Steuerspannungserzeugung anzugeben.

Der Erfindung liegt weiterhin die Aufgabe zugrunde, einen piezoelektrischen Transformator zur Übertragung von Signalen zu schaffen, wobei Eingangs- und Ausgangssignal des Transformators auf deutlich unterschiedlichen Potentialen liegen.

Die erstgenannte Aufgabe wird ausgehend von einer eingangs genannten Röntgeneinrichtung erfindungsgemäß dadurch gelöst, daß die Röntgeneinrichtung einen piezoelektrischen Transformator zur Erzeugung einer Steuerspannung für die Mittel aufweist und der piezoelektrische Transformator dadurch gekennzeichnet ist, daß er mindestens zwei Piezoelemente aufweist, daß zwischen den Piezoelementen ein Isolatorelement zur elektrischen Isolation der Piezoelemente angeordnet ist, daß die Piezoelemente und das Isolatorelement derart angeordnet sind, daß die in einem Piezoelement erzeugten mechanischen Kräfte auf die anderen Piezoelemente übertragen werden und daß am piezoelektrischen Transformator eine Klemmvorrichtung zum Zusammenhalten des piezoelektrischen Transformators angeordnet ist.

Der piezoelektrische Transformator stellt eine einfache, kompakte und preisgünstige Möglichkeit dar, als Ausgangsspannung eine Steuerspannung zu erzeugen, die an die Mittel zur Beeinflussung des Elektronenstroms angelegt wird, und kann einen wesentlichen Teil der Ansteuerelektronik, insbesondere einen herkömmlichen Transformator ersetzen. Gleichzeitig hat ein piezoelektrischer Transformator vorteilhafterweise nur geringe interne Verluste.

Die an dem ersten piezoelektrischen Element, dem sogenannten Aktuator, anliegende und zu transformierende Spannung wird von diesem zunächst in eine mechanische Kraft gewandelt. Über das Isolatorelement, das mechanisch möglichst steif ist, wird die mechanische Kraft auf das zweite piezoelektrische Element, den sogenannten Generator, übertragen, wo die mechanische Kraft wieder in eine elektrische Spannung zurückgewandelt wird. Da Eingangs- und Ausgangsspannung des piezoelektrischen Transformators bei den beschriebenen Anwendungen auf unterschiedlichen Potentialen liegen, ist das zwischen dem Aktuator und dem Generator angeordnete Isolatorelement ausreichend hochspannungsfest, beispielsweise ausreichend dick ausgestaltet, um die zwischen Aktuator und Generator bestehende Potentialdifferenz isolieren zu können. Damit die Kraft vom Aktuator auf den Generator effizient und möglichst verlustfrei übertragen wird, ist erfindungsgemäß vorgesehen, daß am piezoelektrsichen Transformator eine Klemmvorrichtung zum Zusammenhalten des piezoelektrischen Transformators angeordnet ist. Aktuator und Generator und ein gegebenenfalls vorhandener Isolator werden durch diese möglichst steife Klemmvorrichtung derart festgehalten, daß sich die Gesamtlängenabmessung des piezoelektrischen Transformators nicht verändern kann, insbesondere daß sich der piezoelektrische Transformator nicht ausdehnen kann, was eine Verringerung des Wirkungsgrades zur Folge hätte.

Eine Weiterbildung sieht erfindungsgemäß vor, daß die Mittel ein Gitter zur Steuerung des Röhrenstromes oder eine Ablenkvorrichtung zur Ablenkung der von der Kathode emittierten Elektronen aufweisen.

Besonders platzsparend ist eine Ausgestaltung, bei der der piezoelektrische Transformator im Röhrenschutzgehäuse angeordnet ist.

Eine bevorzugte Ausgestaltung sieht erfindungsgemäß vor, daß der piezoelektrische Transformator für den quasistatischen Betrieb vorgesehen ist. Während bekannte piezoelektrische Transformatoren üblicherweise in Resonanz betrieben werden, also nur Wechselspannungen übertragen können, wird der oben beschriebene piezoelektrische Transformator unterhalb jeglicher Eigenresonanz betrieben. Der piezoelektrische Transformator ist deshalb zur Übertragung von sehr niederfrequenten Signalen (z.B. pulsförmigen Gleichspannungssignalen mit Frequenzen von einigen Hertz bis unter ein Hertz) und von Gleichspannungssignalen geeignet. Der besondere Vorteil eines quasistatisch betriebenen piezoelektrischen Transformators liegt darin, daß er eine sehr kurze Anstiegs- und Abfallzeit ausweist, also zum schnellen An- und Abschalten von Spannungen geeignet ist.

Weiterhin ist erfindungsgemäß vorgesehen, daß der piezoelektrische Transformator eingangsseitig auf Erdpotential und ausgangsseitig auf dem Hochspannungspotential der Kathode der Röntgenröhre liegt. Dazu ist insbesondere der oben beschriebene piezoelektrische Transformator geeignet, da bei diesem eine Maßnahme zur Potentialtrennung vorgesehen ist. Es können dabei aber auch herkömmliche piezoelektrische Transformatoren eingesetzt werden, wobei dann andere Maßnahmen zur Potentialtrennung vorzusehen sind.

Da zur Steuerung des Gitters bei einer Röntgenröhre oder zur Ansteuerung einer Ablenkvorrichtung nur relativ kleine Energien benötigt werden, ist die Erzeugung der Steuerspannung für das Gitter oder die Ablenkvorrichtung mit Hilfe eines piezoelektrischen Transformators möglich. Das zu verstärkende Steuersignal wird dem piezoelektrischen Transformator dabei von einer Steuereinrichtung zugeführt.

Die Aufgabe betreffend den piezoelektrischen Transformator wird ausgehend von einem eingangs genannten piezoelektrischen Transformator erfindungsgcmäß dadurch gelöst, daß zwischen den Piezoelementen ein Isolatorelement zur elektrischen Isolation der Piezoelemente angeordnet ist und daß die Piezoelemente und das Isolatorelement derart angeordnet sind, daß die in einem Piezoelement erzeugten mechanischen Kräfte auf die anderen Piezoelemente übertragen werden und daß am piezoelektrischen Transformator eine Klemmvorrichtung zum Zusammenhalten des piezoelektrischen Transformators angeordnet ist.

Eine Weiterbildung dieses piezoelektrischen Transformators sieht erfindungsgemäß vor, daß die Abstände der Elektroden des eingangsseitigen und des ausgangsseitigen Piezoelements unterschiedlich groß sind. Besitzt das ausgangsseitige Piezoelement (Generator) einen wesentliche größeren Elektrodenabstand als das eingangsseitige Piezoelement (Aktuator), so ist die Ausgangsspannung größer als die Eingangsspannung; die Eingangsspannung wird also hochtransformiert. Der Übertragungsfaktor eines derartigen Transformators wird insbesondere bei Anlegen einer Gleichspannung oder einer sehr niederfrequenten Spannung durch das Verhältnis aus Elektrodenabstand beim Generator zu Elektrodenabstand beim Aktuator wesentlich beeinflußt. Je größer dieses Verhältnis ist, desto größer ist der Übertragungsfaktor.

Eine vorteilhafte Ausgestaltung der Erfindung sieht vor, daß ein oder mehrere Piezoelemente aus mehreren piezoelektrischen Schichten aufgebaut sind. Bevorzugt auf der Eingangsseite wird ein aus mehreren Schichten aufgebauter Aktuator, ein sogenannter Multilayer-Aktuator eingesetzt. Auch durch die Anzahl der Schichten wird der Übertragungsfaktor des Transformators beeinflußt. Je mehr Schichten ein Piezoelement aufweist, desto größer ist im allgemeinen der Übertragungsfaktor.

Bevorzugt ist erfindungsgemäß vorgesehen, daß die Piezoelemente und das Isolatorelement zylinderförmig ausgestaltet und übereinander gestapelt angeordnet sind. Diese Ausgestaltung stellt bezüglich Kompaktheit und Preis eine besonders günstige Lösung dar.

In einer vorteilhaften Weiterbildung ist der piezoelektrische Transformator dazu vorgesehen, quasistatisch betrieben zu werden.

Die Erfindung wird nachfolgend anhand der Zeichnungen näher erläutert. Es zeigen:
- Fig. 1: eine Querschnittsdarstellung durch einen erfindungsgemäßen piezoelektrischen Transformator,
- Fig. 2: eine vereinfachte Querschnittsdarstellung einer weiteren Ausgestaltung eines piezoelektrischen Transformators,
- Fig. 3: ein Prinzipschaltbild einer erfindungsgemäßen Röntgeneinrichtung mit Gittersteuerung,
- Fig. 4: ein Prinzipschaltbild einer weiteren erfindungsgemäßen Röntgeneinrichtung mit einer Ablenkvorrichtung für die Elektronen und
- Fig. 5: ein Prinzipschaltbild einer weiteren erfindungsgemäßen Röntgeneinrichtung mit Gittersteuerung.

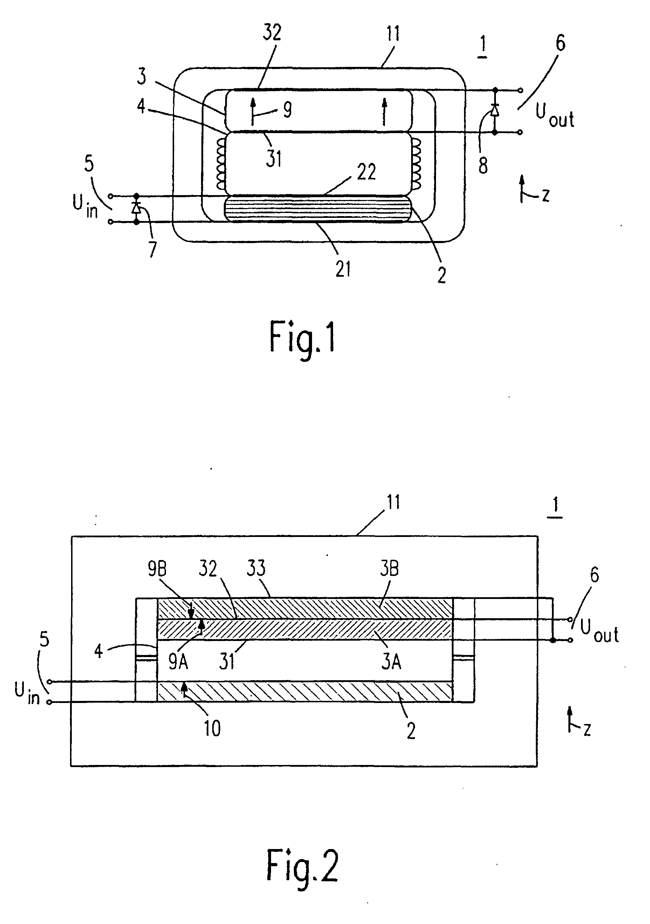

In Fig. 1 ist ein erfindungsgemäßer piezoelektrischer Transformator 1 gezeigt. Schichtweise übereinander gestapelt sind zu erkennen: ein erstes piezoelektrisches Element 2 (der Aktuator), darüber ein Isolatorelement 4, und darüber ein zweites piezoelektrisches Element 3 (der Generator). An der Außenseite des Isolatorelements 4 sind Rippen 5 zur Kriechstreckenverlängerung für die Hochspannung vorgesehen. Der durch mehrere piezoelektrische Schichten gebildete Aktuator 2, ein sog. Multilayer-Aktuator, weist an seiner Unter- und Oberseite jeweils eine Elektrode 21, 22 auf. An diese Elektroden 21, 22 wird am Eingang 5 die zu transformierende Eingangsspannung Uᵢₙ angelegt. Der Generator 3 weist ebenfalls an seiner Unterund Oberseite jeweils eine Elektrode 31, 32 auf, an der die transformierte Ausgangsspannung Uₒᵤₜ am Ausgang 6 abgegriffen werden kann. Die Polarität der piezoelektrischen Schicht des Generators 3 ist durch einen Pfeil 9 angegeben. Aktuator 2, Generator 3 und Isolatorelement 4 sind als zylinderförmige Scheiben mit kreisförmigem Querschnitt ausgestaltet und von einer Klemmvorrichtung 11 umschlossen. Durch diese Klemmvorrichtung 11 ist der Stapel aus Aktuator 2, Isolatorelement 4 und Generator 3 derart fest eingespannt, daß sich der Gesamtstapel nicht in z-Richtung ausdehnen kann, d. h. die Gesamtabmessung des Stapels in z-Richtung kann nicht größer werden, als durch die Klemmvorrichtung 11 vorgegeben ist.

Wenn an den Eingang 5 des piezoelektrischen Transformators 1 eine Spannung angelegt wird, so dehnt sich der Aktuator 2 in z-Richtung aus. Damit diese mechanische Kraft ohne Verluste auf den Generator 3 übertragen wird und eine Stauchung des Generators 3 in z-Richtung bewirkt, muß das Isolatorelement 4 derart steif sein, daß es bei den anliegenden Kräften nicht ebenfalls gestaucht wird. Idealerweise verändern das Isolatorelement 4 und die Klemmvorrichtung 11 ihre Abmessungen in z-Richtung nicht. Aufgrund der Stauchung des Generators 3 wird am Ausgang 6 eine Spannung Uₒᵤₜ erzeugt, die bei der gezeigten Ausgestaltung und bei quasistatischem Betrieb des piezoelektrischen Transformators 1 um einen Faktor größer ist als die Eingangsspannung Uᵢₙ. Der Übertragungsfaktor hängt dabei von dem Verhältnis des Abstandes zwischen den Elektroden 31 und 32 zu dem Abstand zwischen den Elektroden 21 und 22 ab.

Sowohl am Eingang 5 als auch am Ausgang 6 ist zwischen den Anschlußklemmen jeweils eine Schutzdiode 7 bzw. 8 angeschlossen. Sowohl am Eingang 5 als auch am Ausgang 6 können nach einem Spannungssprung von einer hohen zu einer niedrigeren Spannung freie Ladungen als sogenannte Leckströme fließen, die für gewisse Zeit eine Spannung mit entgegengesetzter Polarität bewirken können. Dies kann zu einer Schädigung der Piezoelemente 2 und 3, insbesondere des Multilayer-Aktuators 2 führen, der auf Dauer nur eine Spannung von wenigen Volt mit falscher Polarität unbeschadet übersteht.

Die Wirkungsweise des piezoelektrischen Transformators 1 kann auch umgekehrt werden, indem die Polarisierung der piezoelektrischen Schichten des Aktuators 2 und des Generators 3 umgedreht werden. Dann würde bei Anlegen einer Spannung an den Eingang 5 der Aktuator 2 gestaucht werden, wodurch eine Ausdehnung des Generators 3 bewirkt werden würde, an dem dann wiederum die transformierte Ausgangsspannung abgegriffen werden könnte.

In einer praktischen Ausführung des in Fig. 1 gezeigten piezoelektrischen Transformators betragen die Dicke des aus 90 Schichten bestehenden Aktuators 4mm, des Isolatorelements 10 mm und des Generators 5 mm. Der Durchmesser der kreisförmigen Scheiben beträgt 10 cm. Mit einem derartigen Transformator wird ein Spannungsübertragungsfaktor von etwa 50 erreicht. Für das Isolatorelement ist aufgrund einer hohen Durchschlagfestigkeit sowie einer hohen mechanischen Steifigkeit als Material Aluminiumoxid (Al₂O₃) besonders vorteilhaft. Dieses Material wird vorteilhafterweise auch für die Klemmvorrichtung verwendet, um die thermische Drift (Änderung der mechanischen Verspannung durch unterschiedliche thermische Dehnung) zu verringern. Es kommen aber auch andere mineralische Materialien (Beryllium-Oxid-Keramik, Hartglas, Glas-Keramik, Quarz) als Isolierstoffe in Frage.

In Fig. 2 ist eine weitere Ausgestaltung eines erfindungsgemäßen piezoelektrischen Transformators 1 gezeigt. Im Gegensatz zu der in Fig. 1 gezeigten Ausführungsform sind hier oberhalb des Isolatorelementes 4 auf der Generatorseite zwei piezolektrische Elemente (Generatoren) 3A, 3B übereinander gestapelt. Die Polarität der piezoelektrischen Schichten dieser beiden Generatorelemente 3A, 3B ist entgegengesetzt gerichtet, wie durch die Pfeile 9A und 9B angedeutet ist. Außerdem sind die unterste Elektrode 31 und die oberste Elektrode 33 am Ausgang 6 elektrisch miteinander verbunden. Die zweite Ausgangsanschlußklemme ist mit der mittleren Elektrode 32 verbunden. Durch diese Ausgestaltung wird erreicht, daß auf der Generatorseite eine größere Ladungsmenge erzeugt wird als bei Verwendung nur eines Generatorelements. Während sich die Spannung nur geringfügig ändert, erhöht sich allerdings die Eigenkapazität des Generators 3. Der wesentliche Effekt der Stapelung von zwei (oder mehr) Generatorelementen 3A, 3B, bei denen sich die Polarität benachbarter piezoelektrischer Schichten entgegengesetzt gerichtet ist. besteht darin, daß die sogenannte Spannungszeitkonstante erhöht wird. Die Spannungszeitkonstante ist ein Maß dafür, wie schnell eine am Ausgang anliegende Spannung ohne Veränderung der Eingangsspannung abfällt. Insbesondere im quasistatischen Betrieb soll erreicht werden, daß bei Anliegen einer Gleichspannung am Eingang die transformierte Gleichspannung am Ausgang möglichst lange konstant bleibt und nur langsam von alleine abfällt, daß also die Spannungszeitkonstante möglichst groß ist.

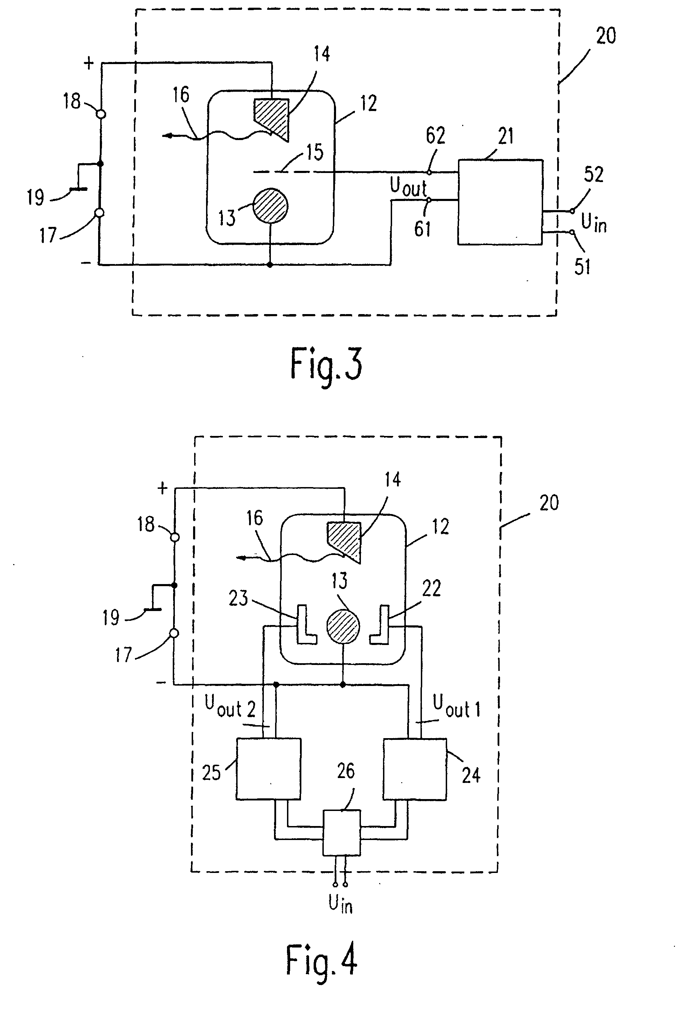

In Fig. 3 ist ein Prinzipschaltbild einer erfindungsgemäßen Röntgeneinrichtung mit einer Röntgenröhre 12 gezeigt. Die Röntgenröhre 12 weist eine Kathode 13, eine Anode 14, an der durch Auftreffen von Elektronen Röntgenstrahlung 16 erzeugt wird, sowie ein Gitter 15 zur Steuerung des Röhrenstromes auf. Durch eine erste Hochspannungsquelle 17 wird die Kathode 13 mit einem gegenüber Erdpotential 19 negativen Hochspannungspotential von beispielsweise -75 kV versorgt, von einer zweiten Hochspannungsquelle 18 wird die Anode 14 mit einer positiven Hochspannung von beispielsweise +75 kV versorgt. Die Steuerung des Gitters 15 erfolgt mittels eines piezoelektrischen Transformators 21, der beispielsweise wie in Fig. 1 oder 2 gezeigt ausgestaltet sein kann. Aufgrund der geringen Abmessungen kann der piezoelektrische Transformator 21 zusammen mit der Röntgenröhre 12 im Röhrenschutzgehäuse 20 angeordnet sein.

Der durch die Röntgenröhre 12 fließende Strom kann mittels einer am Gitter 15 anliegenden Spannung an- und abgeschaltet werden. Für den Sperrbetrieb ist eine gegenüber dem Kathodenpotential negative Spannung von etwa - 3 kV erforderlich, und für den Durchlaßbetrieb eine gegenüber dem Kathodenpotential negative. geringe Spannung von 0 - 400 Volt. Die Gittersteuerspannung Uₒᵤₜ liegt also auf dem Kathodenpotential, d. h. die Bezugselektrode 61 ist mit dem Hochspannungsanschluß der Kathode 13 verbunden und die zweite Ausgangselektrode 62 ist mit dem Gitter 15 verbunden. Die Eingangsspannung Vᵢₙ des piezoelektrischen Transformators 1 liegt dagegen meist auf einem niedrigen Spannungspotential, beispielsweise auf Erdpotential, d. h. die Elektrode 51 ist mit Erdpotential 19 verbunden. Der piezoelektrische Transformator 1 bewirkt also eine Verstärkung des Steuereingangssignals Uᵢₙ bei gleichzeitiger Potentialtrennung zwischen Eingangsund Ausgangssteuersignal Uₒᵤₜ.

Eine derartige Röntgeneinrichtung ist geeignet für Durchleuchtungstechniken, bei denen ein Pulsbetrieb mit hoher Wiederholfrequenz (z.B. 25 Hertz) erforderlich ist, z.B. Herzkatheteruntersuchungen. Aber auch für Durchleuchtungstechniken mit geringer Wiederholfrequenz, beispielsweise bis zu einem halben Hertz, ist diese Röntgeneinrichtung geeignet. Die Gittersteuerspannung für den Sperrbetrieb wie für den Durchlaßbetrieb kann dabei für mehrere hundert Millisekunden konstant gehalten werden. Anderseits ist auch eine Wiederholfrequenz von maximal 125 Hertz möglich. Der besondere Vorteil bei dieser Ausführung liegt dabei darin, daß zum Ein- und Ausschalten des Röhrenstromes nicht die Hochspannungsversorgung von Kathode und Anode an- und abgeschaltet werden muß, sondern daß das Einund Ausschalten des Röhrenstromes durch die Gittersteuerspannung gesteuert wird. Die Hochspannungsversorgung der Röhre kann dabei ständig angeschaltet bleiben.

In Fig. 4 ist ein Prinzipschaltbild einer weiteren erfindungsgemäßen Röntgeneinrichtung gezeigt. Die Röntgenröhre 12 weist dort eine elektromagnetische Ablenkvorrichtung zur Ablenkung des Elektronenstrahls und Einstellung des Brennflecks auf. Die Ablenkvorrichtung weist zwei Ablenkplatten 22, 23 auf, die seitlich neben der Kathode angeordnet sind. Die Ablenkplatten 22, 23 liegen auf einem gegenüber dem Hochspannungspotential der Kathode 13 positiven oder negativen Potential von einigen kV. Diese Steuerspannungen für die Ablenkplatten sind die Ausgangsspannungen Uₒᵤₜ₁, Uₒᵤₜ₂ je eines piezoelektrischen Transformators 24, 25. Eine Steuerungseinheit 26 schaltet das Steuersignal Uᵢₙ auf die Eingänge der piezoelektrischen Transformatoren 24, 25 mit der geeigneten Polarität.

Mit einer derartigen Anordnung können die von der Kathode 13 emittierten Elektronen beeinflußt und abgelenkt werden. Insbesondere kann der Auftreffpunkt der Elektronen auf der Anode 14 um einige mm verschoben werden, was insbesondere bei der Computertomographie Verwendung findet. Dazu wird an die Ablenkplatte 22 abwechselnd eine gegenüber Kathodenpotential positive und negative Spannung angelegt, während an die Ablenkplatte 23 eine Spannung gleicher Größe aber mit umgekehrter Polarität angelegt wird. Unter der Voraussetzung, daß die piezoelektrischen Transformatoren 24, 25 identisch sind, muß dazu das an ihren Eingängen anliegende Signal ebenfalls entgegengesetzte Polarität aufweisen, was durch die Steuerungseinheit 26 gesteuert wird. Es könnten jedoch auch piezoelektrische Transformatoren 24, 25 mit unterschiedlich polarisierten piezoelektrischen Schichten verwendet werden, so daß an ihren Eingängen ein identisches Steuersignal Uᵢₙ angelegt werden kann.

Bei der in Fig. 4 gezeigten Anordnung sind die piezoelektrischen Transformatoren 24, 25, die beispielsweise wie in Fig. 1 oder in Fig. 2 gezeigt ausgestaltet sind, ebenso wie die Steuerungseinheit 26 im Röhrenschutzgehäuse 20 angeordnet.

Mit der in Fig. 4 gezeigten Ausführungsform können auch noch weitere Anwendungen realisiert werden. Beispielsweise können zwei identische Brennflecke im Abstand von mehreren Millimeteren bis einigen Zentimetern dadurch erzeugt werden, daß abwechselnd an eine der beiden Ablenkplatten 22, 23 eine gegenüber Kathodenpotential positive Spannung gelegt wird, während die andere Ablenkplatte jeweils auf negativer Spannung liegt. Mit der gezeigten Ausführungsform ist es auch möglich, eine Nachfokussierung des Brennflecks ("Biasing") oder die Größe des Brennflecks in Abhängigkeit von Applikation und Aufnahmeparametern vorzunehmen durch Einstellung der an den Ablenkplatten 22, 23 anliegenden Spannungspotentiale.

Ausgehend von der in Fig. 3 gezeigten Ausführungsform ist auch eine Röntgeneinrichtung denkbar mit zwei getrennten Kathoden mit jeweils einem Gitter und jeweils einem piezoelektrischen Transformator zur Erzeugung der Gittersteuerspannung. Damit könnten zwei räumlich getrennte, nicht überlagerte Brennflecke erzeugt werden, indem zeitlich nacheinander jeweils eines der Gitter mit einer Sperrspannung und das andere Gitter mit einer Durchlaßspannung versorgt wird.

Sowohl bei der in Fig. 3 als auch bei der in Fig. 4 gezeigten Röntgeneinrichtung können zur Erzeugung der Steuerspannungen statt der in Fig. 1 und 2 gezeigten quasistatisch betriebenen piezoelektrischen Transformatoren mit integrierter Potentialtrennung auch herkömmliche piezoelektrische Transformatoren verwendet werden, die zwei piezoelektrische Schichten, aber keine Isolatorschicht zur Potentialtrennung aufweisen. Denkbar sind piezoelektrische Transformatoren, die im quasistatischen Betrieb, in Resonanz oder bewußt außerhalb der mechanischen Eigenresonanz betrieben werden. Es müssen dann jedoch andere Maßnahmen zur Potentialtrennung getroffen werden, die außerhalb des piezoelektrischen Transformators liegen, da sowohl das Gitter bei einer gittergesteuerten Röntgenröhre als auch die Ablenkvorrichtung bei einer Röntgenröhre mit einstellbarem Brennfleck nur auf Kathodenpotential angesteuert werden können und das Steuersignal meist auf Erdpotential liegt.

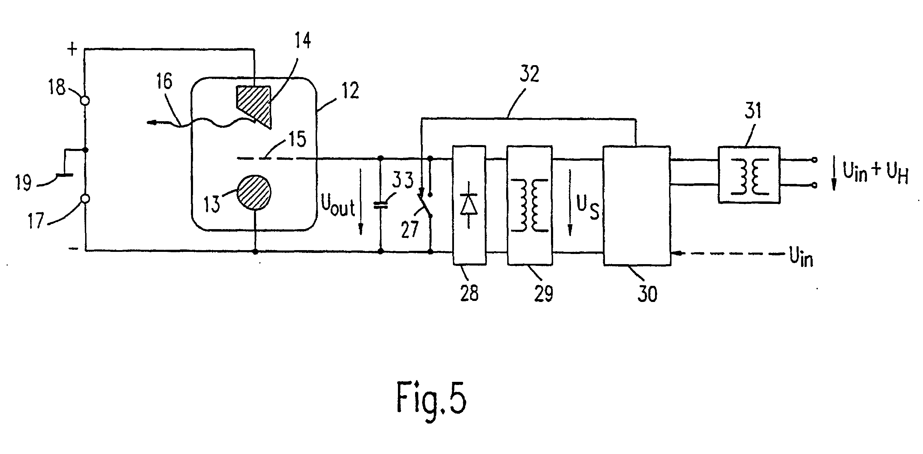

Eine weitere Ausführungsform einer erfindungsgemäßen Röntgeneinrichtung mit einem Gitter 15 zeigt Fig. 5. Das Eingangssteuersignal Uᵢₙ ist dabei der Versorgungsspannung U_{H} für den Heizkreis (zur Heizung der Kathode) aufmoduliert. Ein Leistungsübertrager 31 (Heizwandler) mit hoher Isolierspannung bewirkt eine Spannungsübersetzung auf ein hohes Spannungspotential, beispielsweise auf das Kathodenpotential von -75 kV. In einer Steuer- und Leistungseinheit 30 wird u. a. der Heizstrom für die Kathode geregelt oder ungeregelt weitergeleitet, was auf herkömmliche Art erfolgt und hier nicht weiter erläutert werden soll.

In der Steuer- und Leistungseinheit 30 wird das Eingangssteuersignal Uᵢₙ von der Versorgungsspannung U_{H} getrennt, beispielsweise demoduliert, und es wird ein geeignetes Steuersignal U_{S} erzeugt und an einen piezoelektrischen Transformator 29 weitergeleitet, der das Steuersignal U_{S} hochtransformiert. Das hochtransformierte Ausgangssignal des piezoelektrischen Transformators 29 wird in einer Gleichrichterschaltung 28 gleichgerichtet, und dieses gleichgerichtete Signal Uₒᵤₜ dient dann als Gittersteuerspannung in der oben (Fig. 3) beschriebenen Weise zur An- und Abschaltung der Röntgenröhre.

Ein Kondensator 33 dient zur Glättung der Gittersteuerspannung Uₒᵤₜ. Je nach Anforderung an die Welligkeit des zu glättenden Signals kann die Kapazität des Kondensators 33 verhältnismäßig groß sein, was dazu führt, daß die An- und Abstiegsflanken der Gittersteuerspannung umso flacher verlaufen, je größer die Kapazität ist. Bei großer Kapazität wäre dann ein schnelles An- und Abschalten des Röhrenstromes nicht möglich. Deshalb ist weiterhin ein Schalter 27 vorgesehen, der von der Steuer- und Leistungseinheit 30 gesteuert wird, was durch den Pfad 32 angedeutet werden soll. Der Schalter 27 wird geöffnet, wenn die Gittersteuerspannung Uₒᵤₜ von einer niedrigen Spannung auf eine hohe Spannung umgeschaltet werden soll (z.B. von -200 V auf -3 kV), der Röhrenstrom also abgeschaltet werden soll. Soll die Gittersteuerspannung Uₒᵤₜ von einer hohen Spannung auf eine niedrige Spannung umgeschaltet werden, soll also der Röhrenstrom angeschaltet werden, dann wird der Schalter 27 geschlossen, damit sich die Kapazität schnell entladen kann.

Das Eingangssteuersignal Uᵢₙ muß nicht notwendigerweise der Versorgungsspannung U_{H} aufmoduliert sein, sondern kann auch getrennt beispielsweise über ein faser-optisches Interface der Steuer- und Leistungseinheit 30 zugeführt werden, was gestrichelt in Fig. 5 angedeutet ist. Das Eingangssteuersignal Uᵢₙ kann dann beispielsweise optisch über eine Glasfaserstrecke übertragen werden.

Als piezoelektrischer Transformator 29 wird bei der in Fig. 5 gezeigten Ausführungsform bevorzugt ein herkömmlicher, in Resonanz betriebener piezoelektrischer Transformator verwendet. Möglich ist jedoch auch die Verwendung eines quasistatisch betriebenen piezoelektrischen Transformators ohne integrierte Potentialtrennung, der eine Klemmvorrichtung der in Fig. 1 gezeigten Art aufweist. Bei Verwendung eines solchen piezoelektrischen Transformators entfallen dann die Elemente 26, 27 und 28.

Die Potentialtrennung erfolgt durch den Leistungstransformator 31, welcher bevorzugt ebenso wie die genannten Elemente 26 bis 30 im Röhrenschutzgehäuse angeordnet ist, wodurch die Verwendung von gedämpften Hochspannungskabeln möglich ist. Der Leistungstransformator 31 kann jedoch auch außerhalb des Röhrenschutzgehäuses angeordnet sein, wobei allerdings keine gedämpften Hochspannungskabel verwendet werden können. Ebenso können auch die Elemente 26 bis 30 außerhalb des Röhrenschutzgehäuses angeordnet sein, was jedoch den Nachteil hat, daß statt eines dreipoligen Kabels zwischen Hochspannungserzeuger und Röntgenröhre ein unflexibleres und teureres vierpoliges Kabel benötigt wird, da auch die auf Hochspannungspotential liegende Gittersteuerspannung zugeführt werden muß.

## Patentansprüche

1. Röntgeneinrichtung mit einer Röntgenröhre (12) mit Mitteln *(15,* 22, 23) zur Beeinflussung des durch die Röntgenröhre (12) fließenden Elektronenstroms, die Röntgeneinrichtung einen piezoelektrischen Transformator (21, 24, 25) zur Erzeugung einer Steuerspannung für die Mittel (15, 22, 23) aufweist und der piezoelektrische Transformator **dadurch gekennzeichnet ist, daß** er mindestens zwei Piezoelemente (2, 3) aufweist, daß zwischen den Piezoelementen (2, 3) ein Isolatorelement (4) zur elektrischen Isolation der Piezoelemente (2, 3) angeordnet ist, daß die Piezoelemente (2, 3) und das Isolatorelement (4) derart angeordnet sind, daß die in einem Piezoelement (2, 3) erzeugten mechanischen Kräfte auf die anderen Piezoelemente (2, 3) übertragen werden und daß am piezoelektrischen Transformator (1) eine Klemmvorrichtung (11) zum Zusammenhalten des Piezoelementes und des Isolatorelementes des piezoelektrischen Transformators (1) angeordnet ist.

2. Röntgeneinrichtung nach Anspruch 1,
**dadurch gekennzeichnet, daß** die Mittel ein Gitter (15) zur Steuerung des Röhrenstromes oder eine Ablenkvorrichtung (22, 23) zur Ablenkung der von der Kathode (13) der Röntgenröhre (12) emittierten Elektronen aufweisen.

3. Röntgeneinrichtung nach einem der vorhergehenden Ansprüche,
**dadurch gekennzeichnet, daß** der piezoelektrische Transformator (21, 24, 25) im Röhrenschutzgehäuse (20) angeordnet ist.

4. Röntgeneinrichtung nach einem der vorhergehenden Ansprüche,
**dadurch gekennzeichnet, daß** der piezoelektrische Transformator (1) für den quasistatischen Betrieb vorgesehen ist.

5. Röntgeneinrichtung nach einem der vorhergehenden Ansprüche,
**dadurch gekennzeichnet, daß** der piezoelektrische Transformator (1) eingangsseitig (5) an Erdpotential und ausgangsseitig (6) an Hochspannungspotential der Kathode (13) angeschlossen ist.

6. Piezoelektrischer Transformator (1) mit mindestens zwei Piezoelementen (2, 3),
**dadurch gekennzeichnet, daß** zwischen den Piezoelementen (2, 3) ein Isolatorelement (4) zur elektrischen Isolation der Piezoelemente (2, 3) angeordnet ist, daß die Piezoelemente (2, 3) und das Isolatorelement (4) derart angeordnet sind, daß die in einem Piezoelement (2, 3) erzeugten mechanischen Kräfte auf die anderen Piezoelemente (2, 3) übertragen werden und daß am piezoelektrischen Transformator (1) eine Klemmvorrichtung (11) zum Zusammenhalten des Piezoelementes und des Isolatorelementes des piezoelektrischen Transformators (1) angeordnet ist.

7. Piezoelektrischer Transformator nach Anspruch 6,
**dadurch gekennzeichnet, daß** die Abstände der Elektroden (21, 22; 31, 32) des eingangsseitigen und des ausgangsseitigen Piezoelements (2, 3) unterschiedlich groß sind.

8. Piezoelektrischer Transformator nach Anspruch 6 oder 7,
**dadurch gekennzeichnet, daß** ein oder mehrere Piezoelemente (2, 3) aus mehreren piezoelektrischen Schichten aufgebaut sind.

9. Piezoelektrischer Transformator nach einem der Ansprüche 6 bis 8,
**dadurch gekennzeichnet, daß** die Piezoelemente (2, 3) und das Isolatorelement (4) zylinderförmig ausgestaltet und übereinandergestapelt angeordnet sind.

10. Piezoelektrischer Transformator nach einem oder mehrerer der Ansprüche 6 bis 9,
**dadurch gekennzeichnet, daß** der piezoelektrische Transformator für den quasistatischen Betrieb vorgesehen ist.

## Claims

1. An X-ray device which includes an X-ray tube (12) provided with means (15, 22, 23) for influencing the electron current through the X-ray tube (12), the X-ray device including a piezoelectric transformer (21, 24, 25) for generating a control voltage for the means (15, 22, 23) and the piezoelectric transformer being **characterized in that** it includes at least two piezoelectric elements (2, 3), that an isolator element (4) for electrical isolation of the piezoelectric elements (2, 3) is inserted between the piezoelectric elements (2, 3), that the piezoelectric elements (2, 3) and the isolator element (4) are arranged in such a manner that the mechanical forces produced in one piezoelectric element (2, 3) are transferred to the other piezoelectric elements (2, 3) and the piezoelectric transformer (1) is provided with a clamping device (11) for keeping the piezoelectric elements (2, 3) and the isolator element (4) of the piezoelectric transformer (1) together

2. An X-ray device as claimed in claim 1,
**characterized in that** the means include a grid (15) for controlling the tube current or a deflection device (22, 23) for deflecting the electrons emitted by the cathode (13) of the X-ray tube (12).

3. An X-ray device as claimed in one of the proceding claims,
**characterized in that** the piezoelectric transformer (21, 24, 25) is accommodated in the protective tube housing (20).

4. An X-ray device as claimed in one of the proceding claims,
**characterized in that** the piezoelectric transformer (1) is conceived for quasi-static operation.

5. An X-ray device as claimed in one of the proceding claims,
**characterized in that** the piezoelectric transformer (1) is connected to ground potential at its input side (5) and to high-voltage potential of the cathode (13) at the output side (6).

6. A piezoelectric transformer (1) which includes at least two piezoelectric elements (2, 3),
**characterized in that** between the piezoelectric elements (2, 3) there is inserted an isolator element (4) for electric isolation of the piezoelectric elements (2, 3), that the piezoelectric elements (2, 3) and the isolator element (4) are arranged in such a manner that the mechanical forces produced in one piezoelectric element (2, 3) are transferred to the other piezoelectric elements (2, 3), and that the piezoelectric transformer (1) is provided with a clamping device (11) for keeping the piezoelectric elements (2, 3) and the isolator element (4) of the piezoelectric transformer (1) together.

7. A piezoelectric transformer as claimed in Claim 6,
**characterized in that** the spacing of the electrodes (21, 22; 31, 32) of the piezoelectric element at the input side differs from that of the electrodes of the piezoelectric element (2, 3) at the output side.

8. A piezoelectric transformer as claimed in Claim 6 or 7, **characterized in that** one or more piezoelectric elements (2, 3) consist of a plurality of piezoelectric layers.

9. A piezoelectric transformer as claimed in one of the Claims 6 to 8, **characterized in that** the piezoelectric elements (2, 3) and the isolator element (4) have a cylindrical shape and are stacked on one another.

10. A piezoelectric transformer as claimed in one or more of the claims 6 to 9, **characterized in that** the piezoelectric transformer is conceived for quasi-static operation.

## Revendications

1. Dispositif à rayons X avec un tube à rayons X (12) doté de moyens (15, 22, 23) pour influencer le flux d'électrons circulant par le tube à rayons X (12), le dispositif à rayons X présentant un transformateur piézo-électrique (21, 24, 25) pour la production d'une tension de commande pour les moyens (15, 22, 23) et le transformateur piézo-électrique est **caractérisé en ce qu'**il présente au moins deux piézo-éléments (2,3), qu'un élément isolateur (4) est disposé entre les piézo-éléments (2, 3) pour l'isolation électrique des piézo-éléments (2, 3), que les piézo-éléments (2, 3) et l'élément isolateur (4) sont disposés de telle sorte que les forces mécaniques produites dans un piézo-élément (2, 3) sont transmises sur les autres piézo-éléments (2, 3) et qu'un dispositif de serrage (11) est disposé sur le transformateur piézo-électrique (1) pour maintenir les piézo-éléments (2,3) et l'élément isolateur du transformateur piézo-électrique (1).

2. Dispositif à rayons X selon la revendication 1,
**caractérisé en ce que** les moyens présentent une grille (15) pour la commande du courant du tube ou un dispositif de déviation (22, 23) pour dévier les électrons émis par la cathode (13) du tube à rayons X.

3. Dispositif à rayons X selon l'une des revendications précédentes,
**caractérisé en ce que** le transformateur piézo-électrique (21, 24, 25) est disposé dans le boîtier de protection du tube (20).

4. Dispositif à rayons X selon l'une des revendications précédentes,
**caractérisé en ce que** le transformateur piézo-électrique (1) est prévu pour un fonctionnement quasi statique.

5. Dispositif à rayons X selon l'une des revendications précédentes,
**caractérisé en ce que** le transformateur piézo-électrique (1) est raccordé côté entrée (5) au potentiel de terre et côté sortie (6) au potentiel de haute tension de la cathode (13).

6. Transformateur piézo-électrique (1) avec au moins deux piézo-éléments (2, 3),
**caractérisé en ce qu'**un élément isolateur (4) est disposé entre les piézo-éléments (2, 3) pour l'isolation électrique des piézo-éléments (2, 3), que les piézo-éléments (2, 3) et l'élément isolateur (4) sont disposés de telle sorte que les forces mécaniques produites dans un piézo-élément (2, 3) sont transmises sur les autres piézo-éléments (2, 3) et qu'un dispositif de serrage (11) est disposé sur le transformateur piézo-électrique (1) pour maintenir les piézo-éléments (2, 3) et l'élément isolateur (4) du transformateur piézo-électrique (1).

7. Transformateur piézo-électrique selon la revendication 6,
**caractérisé en ce que** les intervalles entre les électrodes (21, 22. 31, 32) des piézo-éléments côté entrée et côté sortie (2, 3) sont de taille différente.

8. Transformateur piézo-électrique selon l'une des revendications 6 ou 7,
**caractérisé en ce qu'**un ou plusieurs piézo-éléments (2, 3) sont composés de plusieurs couches piézo-électriques.

9. Transformateur piézo-électrique selon l'une des revendications 6 à 8,
**caractérisé en ce que** les piézo-éléments (2, 3) et l'élément isolateur (4) sont conçus en forme de cylindre et sont empilés.

10. Transformateur piézo-électrique selon l'une ou plusieurs des revendications 6 à 9,
**caractérisé en ce que** le transformateur piézo-électrique est prévu pour un fonctionnement quasi statique.
